Europäisches Patentamt

European Patent Office

Office européen des brevets

(19)

(11) Numéro de publication : **0 424 240 B1**

## (12) FASCICULE DE BREVET EUROPEEN

(45) Date de publication du fascicule du brevet :
**24.11.93 Bulletin 93/47**

(51) Int. Cl.⁵ : **H03H 9/145**

(21) Numéro de dépôt : **90402888.3**

(22) Date de dépôt : **16.10.90**

(54) **Transducteur d'ondes de surface unidirectionnel.**

(30) Priorité : **20.10.89 FR 8913747**

(43) Date de publication de la demande :
**24.04.91 Bulletin 91/17**

(45) Mention de la délivrance du brevet :
**24.11.93 Bulletin 93/47**

(84) Etats contractants désignés :
**DE GB**

(56) Documents cités :
**EP-A- 0 140 618**
**EP-A- 0 184 508**
**PROCEEDINGS OF THE 40TH ANNUAL FRE-**
**QUENCY CONTROL SYMPOSIUM, Philadel-**
**phia, PA, 1986, pages 269-274, IEEE, New**
**York, US; T.N. OLIVER et al.: "Low loss, highly**
**stable saw devices on quartz"**

(73) Titulaire : **THOMSON-CSF**
**51, Esplanade du Général de Gaulle**
**F-92800 Puteaux (FR)**

(72) Inventeur : **Dufilie, Pierre**
**THOMSON-CSF SCPI Cédex 67**
**F-92045 Paris la Défense (FR)**
Inventeur : **Desbois, Jean**
**THOMSON-CSF SCPI Cédex 67**
**F-92045 Paris la Défense (FR)**

(74) Mandataire : **Desperrier, Jean-Louis et al**
**THOMSON-CSF SCPI B.P. 329 50, rue**
**Jean-Pierre Timbaud**
**F-92402 Courbevoie Cédex (FR)**

## Description

La présente invention se rapporte aux transducteurs d'ondes de surface unidirectionnels qui permettent d'émettre à la surface d'un substrat une onde de surface de telle manière que l'essentiel du signal sorte par une extrémité de ce transducteur et que le signal éventuel sortant par l'autre extrémité du transducteur soit d'un niveau très bas par rapport au signal principal.

Il est connu pour réaliser des transducteurs unidirectionnels uniphasés d'utiliser des réflecteurs internes dont le centre de phase de réflexion est décalé par rapport à celui des sources électro-acoustiques. On utilise pour cela généralement soit des électrodes flottantes, soit des couches métalliques ou diélectriques superposées aux métallisations des électrodes. Dans le cas des électrodes flottantes le pas de celles-ci est de $\lambda/8$ et la précision de gravure nécessaire pour obtenir ce pas limite donc les fréquences accessibles. Dans le cas des couches superposées, il faut utiliser un procédé de fabrication à plusieurs niveaux, ce qui complique sérieusement les choses et augmente sensiblement le coût.

Pour surmonter ces inconvénients l'invention propose un transducteur d'ondes de surface unidirectionnel, caractérisé en ce qu'il comprend un alignement en succession alternée de cellules émettrices et réflectrices séparées par des frontières conventionnelles gauche et droite ; chaque cellule émettrice pouvant émettre par ses frontières gauche et droite des ondes en opposition de phase et chaque cellule réflectrice ayant à chacune de ses frontières gauche et droite des coefficient de réflexion en opposition de phase.

D'autres particularités et avantages de l'invention apparaîtront clairement dans la description suivante présentée à titre d'exemple non limitatif et faite en regard des figures annexées qui représentent :
- la figure 1 : le schéma d'un transducteur acoustique distribué monocanal ;
- la figure 2 : le schéma d'un transducteur acoustique distribué multicanaux ;
- la figure 3 : le schéma d'un transducteur unidirectionnel ;
- la figure 4 : une cellule émettrice d'un transducteur selon l'invention ;
- la figure 5 : une cellule réflectrice d'un tel transducteur ; et
- la figure 6 : une vue en coupe d'un transducteur selon l'invention ;
- la figure 7 : une vue en coupe d'une variante d'un transducteur selon l'invention.

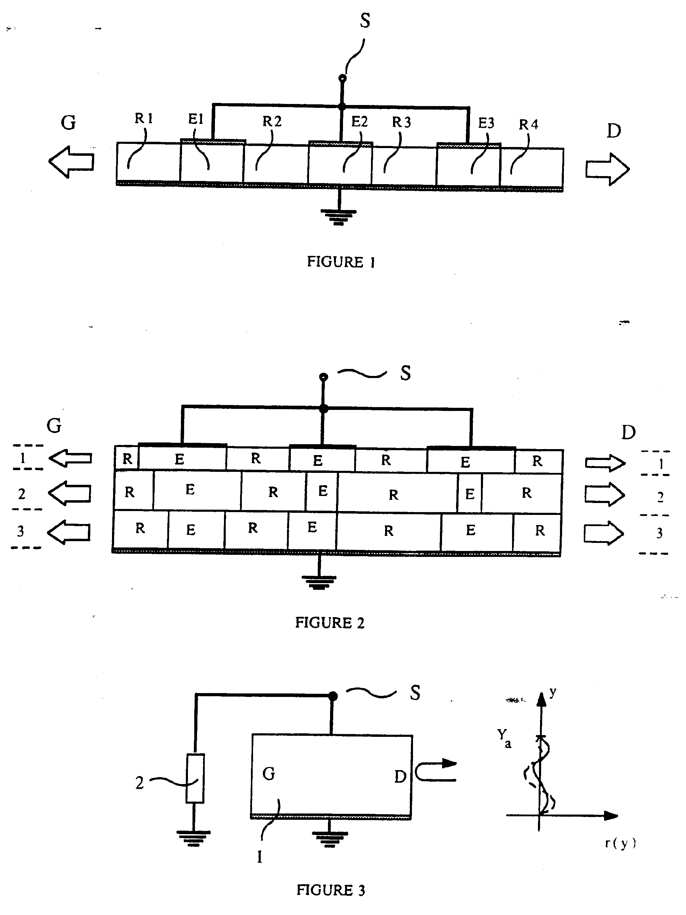

On a représenté sur la figure 1 la structure générale des électrodes d'un transducteur à réflexion acoustique distribuée, telles qu'elles sont placées sur la surface d'un substrat piézoélectrique qui n'est pas représenté sur la figure. Ces électrodes sont représentées par des rectangles à l'intérieur desquels on a disposé des moyens d'excitation non représentés, qui se présentent généralement sous la forme de peignes interdigités. Ces peignes sont reliés l'un à la masse et l'autre à une connexion électrique S. Lorsque un signal électrique est appliqué en S, une onde acoustique est générée à chacun des accès acoustiques gauche (G) et droit (D), constitués par les extrémités du transducteur. Cet ensemble est d'ailleurs réversible, et les ondes acoustiques se propageant sur la surface du substrat peuvent arriver par ces accès pour exciter le transducteur afin qu'il délivre un signal électrique sur la connexion S.

Les électrodes sont groupées sous forme de cellules émettrices $E_1$ à $E_3$ et réflectrices $R_1$ à $R_4$ alignées de manière alternée sur l'axe de propagation des ondes acoustiques. Seules les cellules émettrices sont reliées à la connexion électrique S et excitent donc des ondes acoustiques à la surface du substrat, alors que les cellules réflectrices modifient les caractéristiques de propagation acoustique le long de cet axe.

On a représenté sur la figure 2 la structure générale d'un transducteur comprenant plusieurs voies acoustiques, 1 à 3 dans cet exemple, dont les caractéristiques sont différentes, notamment en fonction de la fréquence des ondes à émettre. Pour cela on a mis côte à côte trois transducteurs semblables à celui de la figure 1 et comportant chacun un ensemble de cellules émettrices E et un ensemble de cellules réceptrices R. Quand le nombre de voies acoustiques ainsi obtenues devient grand, on obtient à la limite un transducteur pondéré.

On a représenté sur la figure 3 de manière très schématique un transducteur à réflexion acoustique distribuée 1 relié par l'intermédiaire d'une électrode de sortie S et par la masse à une charge 2. Le coefficient de réflexion global F à l'un des accès acoustiques de ce dispositif est, pour une valeur donnée de l'impédance de charge 2, la somme du coefficient de réflexion mesuré lorsque S est relié directement à la masse, et de la réémission acoustique induite par la tension sur S. L'amplitude et la phase de cette tension dépendent de l'impédance de charge 2. coefficient de réflexion r(y), mesuré le long de l'axe y de propagation des ondes acoustiques est représenté sur le graphique de la droite de la figure par la courbe en trait plein désignant la partie réelle de ce coefficient par la courbe en traits pointillés sa partie imaginaire.

F est alors donné par la formule :

$$F = \frac{1}{y_a} \int_0^{y_a} r(y)\, dy$$

On peut ainsi annuler F en choisissant judicieusement l'impédance de charge, ce qui permet d'éliminer ainsi, pour un filtre ou pour une ligne à retard, l'écho de triple transit.

On peut par ailleurs concevoir le transducteur de manière à obtenir un transfert électroacoustique nul entre l'entrée électrique S et l'un des accès acoustique. Dans un tel cas on obtient donc un transducteur unidirectionnel uniphasé.

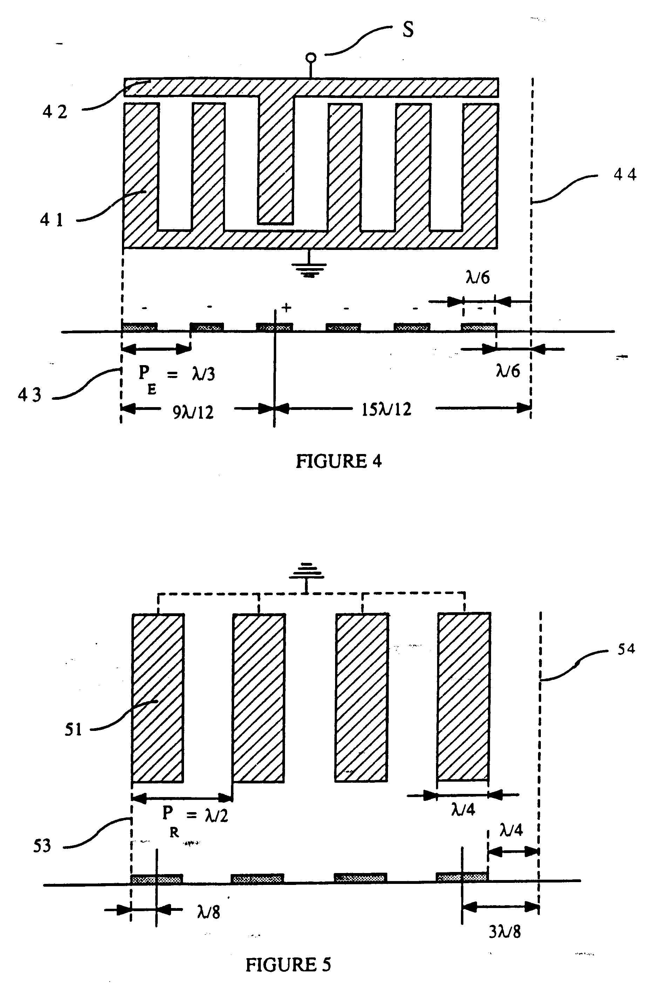

On a représenté sur la figure 4 deux vues d'une cellule émettrice E, une vue de dessus située en haut de la figure et une vue en coupe située en bas de la figure en correspondance avec la vue d'en haut. Les deux électrodes sont en forme de peignes interdigités. L'électrode 41 reliée à la masse comprend 5 dents et l'électrode 42 reliée à la borne S n'en comprend qu'une. Ces dents sont réparties avec un pas $P_E = \lambda/3$, en prenant pour $\lambda$ la longueur d'onde moyenne de fonctionnement du dispositif, et la succession des dents est telle que l'on a, en partant de la gauche vers la droite, deux dents de l'électrode 41, la dent de l'électrode 42, et les trois dernières dents de l'électrode 41. Si donc on définit par convention une frontière gauche 43 située sur le bord extérieur de la première dent à gauche de l'électrode 41, et une frontière droite 44 située sur le bord extérieur de l'électrode 41 à $\lambda/6$ du bord externe de la dernière dent de cette même électrode, le centre de la dent unique de l'électrode 42 sera situé à $9\,\lambda/12$ de la frontière gauche et à $15\,\lambda/12$ de la frontière droite.

Compte tenu de la différence des trajets acoustiques des ondes entre la dent unique de l'électrode 42, notée + sur la figure par convention, et les frontières gauche et droite de la cellule telles que définies plus haut par rapport aux dents extrêmes de l'électrode 41, notée - par convention, on obtient une différence de marche de $\lambda/2$, correspondant à un déphasage de 180°, entre les ondes se propageant vers la gauche et vers la droite lorsqu'elles arrivent aux frontières gauche et droite de la cellule E.

La cellule représentée sur la figure 4 est un exemple très particulier et non limitatif d'une cellule émettrice et on peut, en particulier pour augmenter l'efficacité d'émission des ondes, l'agrandir en la reproduisant à l'identique par simple translation de 6 pas élémentaires $P_E$. Les cellules ainsi obtenues auront donc N dents pour l'électrode 42 et 5N dents pour l'électrode 41, et ces dents se succèderont selon la séquence définie par la figure 4.

On a représenté sur la figure 5, avec les mêmes conventions que sur la figure 4, une cellule réflectrice comportant un ensemble d'électrodes linéaires 51. Ces électrodes sont espacées avec un pas $P_R = \lambda/2$ et elles peuvent être soit isolées soit réunies entre elles et à la masse, c'est-à-dire en court-circuit. On définit comme pour la cellule émettrice une frontière gauche 53 située sur le bord extérieur de la première électrode à gauche, et une frontière droite 54 située à $\lambda/4$ du bord extérieur de la dernière électrode à droite. Chaque électrode se comporte comme un réflecteur élémentaire et il est connu que le coefficient de réflexion de chacun de ces réflecteurs est imaginaire pur si l'on prend comme référence de phase pour les ondes incidentes et réfléchies l'axe de symétrie de ce réflecteur. Ceci revient à dire que la réflexion se fait avec un changement de phase de + ou -90°. La détermination entre + ou - dépend des propriétés physiques des matériaux et du substrat en relation avec le fait que les dents sont isolées ou réunies en court-circuit. Dans le cas le plus général, on a le signe + quand les dents sont en court-circuit et le signe - lorsque les dents sont isolées. Dans la suite de la description, on considérera le signe + mais l'invention est aussi valable dans le cas où l'on a le signe -.

Dans ces conditions, en prenant comme origine de référence la frontière gauche 53, la différence de phase sur cette frontière gauche entre l'onde incidente et l'onde réfléchie sur le premier réflecteur 51 est égale à 180°, ou $\lambda/2$, puisqu'on a un changement de phase de 90° dû à la réflexion et un changement de 90° dû au trajet aller et retour sur une longueur égale à $\lambda/4$ entre la frontière gauche et le centre du réflecteur. La distance entre les réflecteurs étant égale à $\lambda/2$, le trajet aller et retour pour les ondes réfléchies sur les autres réflecteurs sera toujours égal à $M\lambda/2$ et les ondes réfléchies seront ainsi en phase et elles aussi déphasées de 180° sur la frontière gauche par rapport à l'onde incidente.

Lorsque les ondes acoustiques arrivent par la droite, elles se réfléchissent elles aussi sur les réflecteurs et, en prenant pour origine des phases la frontière droite 54, la longueur du trajet aller et retour est égale à $3\,\lambda/4$, ce qui compte tenu du changement de phase de $\lambda/4$ dû à la réception donne $\lambda$ soit 360°. Ainsi la phase du coefficient de réflexion sur la frontière droite est nulle, à 360° près.

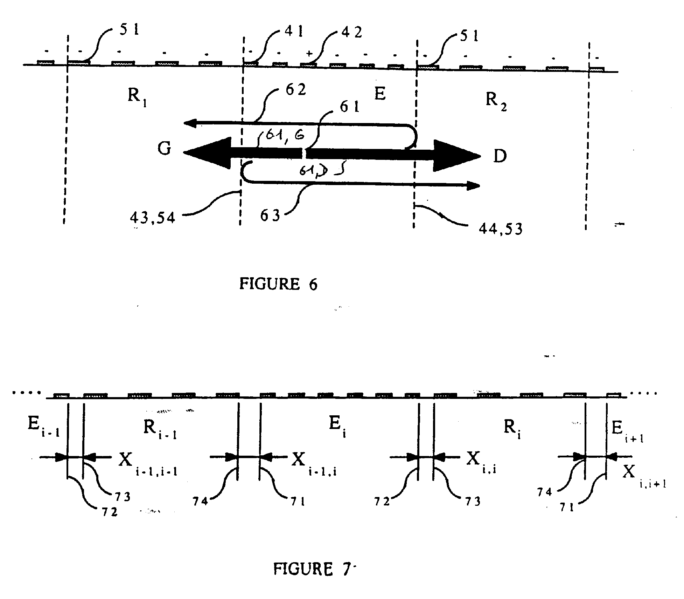

On a représenté sur la figure 6 une vue en coupe d'une cellule émettrice E identique à celle de la figure 4, entourée par deux cellules réflectrices $R_1$ et $R_2$ identiques à celle de la figure 5. Les écartements respectifs de ces cellules sont tels que la frontière droite de la cellule $R_1$ coïncide avec la frontière gauche de la cellule émettrice, selon une frontière 43,54, et que la frontière droite de la cellule émettrice coïncident avec la frontière gauche de la cellule réflectrice $R_2$ selon une frontière 44,53. La cellule transductrice E émet donc une onde représentée par le trait 61 sur la figure 6. Cette onde est émise aussi bien vers la gauche que vers la droite et elle présente au niveau des frontières 43,54 et 44,53 une différence de phase de 180° comme on l'a montré plus haut.

L'onde 61,D se réfléchit sur le réflecteur $R_2$ pour donner une première onde réfléchie qui se dirige vers la gauche et est représentée en 62 sur la figure.

La réflexion sur la frontière gauche 44,53 de la cellule réflectrice $R_2$ entraîne, comme on l'a montré plus haut, un changement de phase de 180°. La traversée de la cellule émettrice E entraîne pour cette première onde réfléchie une rotation de phase égale à 2 fois 360° dans le cas de la figure, où avec six dents le trajet est égal à 2λ. Dans le cas d'une cellule émettrice N fois plus grande, le changement de phase sera égal à 2N x 360°. Au total il y a donc conservation de la phase.

Dans ces conditions l'onde réfléchie 62 est donc, par rapport à l'onde émise 61,G en phase sur la frontière 43,54 et ces deux ondes interférent constructivement, c'est-à-dire s'additionnent.

L'onde 61,G émise vers la gauche se réfléchit sur la frontière droite, 43,54, de la cellule réflectrice R₁ pour donner une deuxième onde réfléchie représentée par une ligne 63 sur la figure.

En appliquant le même raisonnement que précédemment, on constate que l'onde réfléchie 63 présente cette fois-ci sur la frontière 44,53 une différence de phase de 180° par rapport à l'onde directe 61,D puisque, comme expliqué plus haut, la réflexion au niveau de la frontière 43,54 s'effectue sans changement de phase. L'onde 63 et l'onde 61, D interférent destructivement, ce qui amène à une atténuation très importante de l'onde résiduelle se propageant vers la droite de la figure.

On voit donc qu'on a ainsi obtenu un transducteur qui émet essentiellement une onde vers la gauche de la figure.

La structure simple de la figure 6 comportant une cellule émettrice entourée de deux cellules réflectrices peut sans difficultés être étendue à un très grand nombre de cellules émettrices et réflectrices juxtaposées comme dans la figure 1. Il n'est pas alors nécessaire que toutes ces cellules soient identiques entre elles, pourvu qu'on respecte les conditions de phase décrites plus haut. C'est ainsi que le nombre de réflecteurs élémentaires 51 peut être différent d'une cellule à l'autre et que le nombre d'électrodes 42 et 41 des cellules émettrices peut lui aussi être différent d'une cellule à l'autre comme on l'a vu plus haut.

On remarque que si le coefficient de réflexion propre a chaque réflecteur élémentaire des cellules R est égal à -90°, le fonctionnement de l'ensemble est inversé et qu'on obtient un transducteur unidirectionnel de la gauche vers la droite.

Le dispositif ainsi décrit présente l'avantage de pouvoir être fabriqué selon un procédé utilisant un seul niveau de gravure, que ce soit par dépôt d'une couche conductrice ou diélectrique ou par gravure de sillons dans le substrat. Lorsque les réflecteurs élémentaires 51 sont conducteurs et en court-circuit on obtient une protection contre les effets électrostatiques et pyroélectriques.

Enfin les dimensions caractéristiques des éléments du transducteur sont limitées à 2, λ/4 et λ/6, et on peut donc obtenir des dispositifs fonctionnant à des fréquences plus élevées que ceux qui utilisent une géométrie à λ/8.

Comme on l'a déjà dit un tel transducteur n'est rigoureusement (aux imperfections près) unidirectionnel que pour la fréquence (centrale en principe) qui sert de base aux calculs.

Dans certains cas on peut sacrifier en partie les caractéristiques unidirectionnelles au profit d'autres paramètres. C'est en particulier le cas dans la synthèse des filtres où le nombre de paramètres à rendre compatibles entre eux est très grand.

Dans un tel cas on modifie les intervalles entre les cellules émettrice et réflectrice pour obtenir les caractéristiques voulues.

Ainsi sur la figure 7, selon les conventions utilisées dans cette description, les frontières entre la cellule $E_i$ et les cellules $R_{i-1}$ et $R_i$ sont situées en 71 et 73. En appelant 74 et 72 les bords des doigts de $E_i$ et de $R_{i-1}$ qui font face à ces frontières 71 et 73 on obtient des intervalles $X_{i-1,i}$ et $X_{i,i}$ respectivement entre 74 et 71 et entre 72 et 73.

Lorsque $X_{i-1,i} = λ/4$ et $X_{i,i} = λ/6$ on retrouve le transducteur unidirectionnel décrit plus haut et la figure 7 est identique à la figure 6.

Par contre lorsque l'on modifie dans une proportion faible devant λ/6 ces distances, le transducteur n'est plus complètement unidirectionnel mais ses autres caractéristiques se modifient pour être plus adaptées à d'autres usages.

On remarque que ceci revient à partir, pour les calculs, d'une valeur de λ ne correspondant pas à la fréquence centrale de la bande passante utilisée.

L'invention n'est pas limitée à des cellules E ne possédant qu'un seul accès électrique. Elle s'étend à des cellules E ayant plusieurs accès telles que les transducteurs triphasés.

D'autre part le nombre de dents d'une cellule E n'est pas limité à un multiple de 3.

**Revendications**

1. Transducteur d'ondes de surface unidirectionnel, caractérisé en ce qu'il comprend un alignement en succession alternée de cellules émettrices (E) et réflectrices (R) séparées par des frontières conventionnelles gauche (43,53) et droite (44,54) ; chaque cellule émettrice pouvant émettre par ses frontières gauche et droite des ondes en opposition de phase et chaque cellule réflectrice ayant à chacune de ses frontières gauche et droite des coefficient de réflexion en opposition de phase.

2. Transducteur selon la revendication 1, caractérisé en ce que les cellules émettrices (E) sont constituées de deux électrodes (41, 42) en forme de peignes interdigités présentant un pas ($P_E$) égal à λ/3 ; λ étant la longueur d'onde centrale de fonctionnement du transducteur.

3. Transducteur selon la revendication 2, caractérisé en ce que la frontière gauche (43) d'une cellule émettrice est située le long du bord externe de la dent la plus à gauche de cette cellule ; et que la frontière droite (44) est située à une distance égale à λ/6 du bord externe de la dent la plus à droite de la cellule les dents étant larges de λ/6.

4. Transducteur selon l'une quelconque des revendications 2 et 3, caractérisé en ce que l'une des électrodes (42) comporte une seule dent et que l'autre électrode (41) comprend 5 dents.

5. Transducteur selon la revendication 4, caractérisé en ce que la dent unique de l'une des électrodes (42) est située par rapport au 5 dents de l'autre électrode (41) de manière à ce que deux de ces cinq dents soient placées d'un côté de cette électrode et les trois autres de l'autre côté.

6. Transducteur selon l'une quelconque des revendications 1 à 5, caractérisé en ce que chaque cellule réflectrice comporte un ensemble de réflecteurs élémentaires (51) disposés selon un pas élémentaire égal à λ/2 ; la frontière gauche (53) de la cellule étant située le long du bord externe du réflecteur élémentaire le plus à gauche et la frontière droite (54) de la cellule étant situé à une distance égale à λ/4 du bord externe du réflecteur le plus à droite ; chaque réflecteur ayant une largeur égale à λ/4.

7. Transducteur selon la revendication 6, caractérisé en ce que les réflecteurs élémentaires sont des électrodes isolées.

8. Transducteur selon la revendication 6, caractérisé en ce que les réflecteurs élémentaires sont des électrodes en court-circuit.

9. Transducteur selon la revendication 2, caractérisé en ce que la frontière gauche (71) d'une cellule émettrice est située à une distance faible devant λ/6 du bord externe de la dent la plus à gauche de cette cellule et que la frontière droite (73) est située à une distance faible devant λ/6 du bord externe de la dent la plus à droite de la cellule, les dents étant larges de λ/6.

**Patentansprüche**

1. Oberflächenwellen-Richtwandler, dadurch gekennzeichnet, daß er eine geradlinige Anordnung von nacheinander wechselnden Sende- (E) und Reflexionszellen (R) enthält, die durch linke (43, 53) und rechte (44, 54) konventionelle Grenzen getrennt sind; wobei jede Sendezelle durch ihre linken und rechten Grenzen Wellen mit entgegengesetzter Phase aussenden kann und wobei jede Reflexionszelle an jeder ihrer linken und rechten Grenzen Reflexionskoeffizienten mit entgegengesetzter Phase besitzt.

2. Wandler gemäß Anspruch 1, dadurch gekennzeichnet, daß die Sendezellen (E) aus zwei Elektroden (41, 42) in Form von Interdigitationskämmen gebildet sind, die eine Schrittweite ($P_E$) aufweisen, die gleich λ/3 ist; wobei λ die zentrale Betriebswellenlänge des Wandlers ist.

3. Wandler gemäß Anspruch 2, dadurch gekennzeichnet, daß sich die linke Grenze (43) einer Sendezelle entlang einer Außenkante des am weitesten links befindlichen Zahns dieser Zelle befindet und daß sich die rechte Grenze (44) in einem Abstand von λ/6 von der Außenkante des am weitesten rechts befindlichen Zahns der Zelle befindet; wobei die Zähne eine Breite von λ/6 besitzen.

4. Wandler gemäß einem der Ansprüche 2 und 3, dadurch gekennzeichnet, daß eine der Elektroden (42) einen einzigen Zahn enthält und daß die andere Elektrode (41) 5 Zähne enthält.

5. Wandler gemäß Anspruch 4, dadurch gekennzeichnet, daß der einzige Zahn einer der Elektroden (42) in bezug auf die 5 Zähne der anderen Elektrode ( 41) so angeordnet ist, daß sich zwei dieser fünf Zähne auf einer Seite dieser Elektrode und die drei anderen auf der anderen Seite befinden.

6. Wandler gemäß einem der Ansprüche 1 bis 5, dadurch gekennzeichnet, daß jede Reflexionszelle eine Gruppe von Elementarreflektoren (51) enthält, die mit einer Elementarschrittweite angeordnet sind, die gleich λ/2 ist; wobei sich die linke Grenze (53) der Zelle entlang der Außenkante des am weitesten links befindlichen Elementarreflektors befindet und die rechte Grenze (54) der Zelle in einem Abstand von λ/4 von der Außenkante des am weitesten rechts befindlichen Reflektors befindet; wobei jeder Reflektor eine Breite von λ/4 besitzt.

7. Wandler gemäß Anspruch 6, dadurch gekennzeichnet, daß die Elementarreflektoren isolierte Elektroden sind.

8. Wandler gemäß Anspruch 6, dadurch gekennzeichnet, daß die Elementarwandler kurzgeschlossene Elektroden sind.

9. Wandler gemäß Anspruch 2, dadurch gekennzeichnet, daß sich die linke Grenze (71) einer Sendezelle in einem gegen λ/6 kleinen Abstand von der Außenkante des am weitesten links befindlichen Zahns dieser Zelle befindet und daß sich die rechte Grenze (73) in einem gegen λ/6 kleinen Abstand von der Außenkante des am weitesten rechts befindlichen Zahns dieser Zelle befindet, wobei die Zähne eine Breite von λ/6 besitzen

**Claims**

1. Unidirectional surface wave transducer characterised in that it comprises an alternating successional alignment of emitter cells (E) and reflector cells (R) separated by conventional left (43, 53) and right (44, 54) boundaries; each emitter cell being able to emit waves in phase opposition via its left and right boundaries and each reflector cell having reflection coefficients in phase opposition at each of its left and right boundaries.

2. Transducer according to Claim 1, characterised in that the emitter cells (E) consist of two electrodes (41, 42) in the form of interdigital combs with a spacing ($P_E$) equal to λ/3; λ being the central operating wavelength of the transducer.

3. Transducer according to Claim 2, characterised in that the left boundary (43) of an emitter cell is situated along the outer edge of the leftmost tooth of this cell, and that the right boundary (44) is situated a distance equal to λ/6 from the outer edge of the right-most tooth of the cell; the teeth being λ/6 wide.

4. Transducer according to either one of Claims 2 or 3, characterised in that one of the electrodes (42) includes a single tooth and that the other electrode (41) comprises 5 teeth.

5. Transducer according to Claim 4, characterised in that the single tooth of one of the electrodes (42) is situated with respect to the 5 teeth of the other electrode (41) in such a way that two of these five teeth are placed to one side of this electrode and the other three to the other side.

6. Transducer according to any one of Claims 1 to 5, characterised in that each reflector cell includes a set of elementary reflectors (51) arranged according to an elementary spacing equal to λ/2; the left boundary (53) of the cell being situated along the outer edge of the leftmost elementary reflector and the right boundary (54) of the cell being situated a distance equal to λ/4 from the outer edge of the rightmost reflector; each reflector having a width equal to λ/4.

7. Transducer according to Claim 6, characterised in that the elementary reflectors are isolated electrodes.

8. Transducer according to Claim 6, characterised in that the elementary reflectors are short-circuited electrodes.

9. Transducer according to Claim 2, characterised in that the left boundary (71) of an emitter cell is situated a distance which is small compared with λ/6 from the outer edge of the leftmost tooth of this cell and that the right boundary (73) is situated a distance which is small compared with λ/6 from the outer edge of the rightmost tooth of the cell, the teeth being λ/6 wide.

FIGURE 1

FIGURE 2

FIGURE 3

7

S

4 2

4 1

4 3

4 4

λ/6

λ/6

$P_E = λ/3$

9λ/12

15λ/12

FIGURE 4

54

51

53

$P_R = λ/2$

λ/4

λ/4

λ/8

3λ/8

FIGURE 5

FIGURE 6

FIGURE 7